(19)

Europäisches
Patentamt
European
Patent Office
Office européen
des brevets

(11) **EP 2 669 695 A2**

(12) **EUROPEAN PATENT APPLICATION**

(43) Date of publication:
**04.12.2013 Bulletin 2013/49**

(51) Int Cl.:
**G01R 31/36** (2006.01)

(21) Application number: **13169475.4**

(22) Date of filing: **28.05.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **29.05.2012 JP 2012122024
26.04.2013 JP 2013093376**

(71) Applicant: **GS Yuasa International Ltd.
Kisshoin
Minami-ku, Kyoto-shi
Kyoto 601-8520 (JP)**

(72) Inventor: **Nakamura, Masashi
Kyoto-shi, Kyoto 601-8520 (JP)**

(74) Representative: **Grünecker, Kinkeldey,
Stockmair & Schwanhäusser
Leopoldstrasse 4
80802 München (DE)**

(54) **Internal resistance estimation device and method of estimating internal resistance**

(57)      An objective is to estimate an internal resistance of an electric storage device. A battery pack includes a current measurement portion, a voltage measurement portion, and a CPU. The current measurement portion is configured to measure a current value I of a current flowing through a cell. The voltage measurement portion is configured to measure a voltage value V of a voltage across the cell, which is a voltage in charge time. The CPU is configured to estimate an internal resistance of the cell based on the current value I and the voltage value V measured in a ramp region LA of the charge time in which a time variation $\Delta I$ in current value I is maintained constant. In the battery pack, the internal resistance of the cell can be accurately estimated during the charge time because the time variation $\Delta I$ in current value I is maintained constant in the ramp region LA.

FIG.4

**Description**

Field

The present invention relates to a technology for estimating an internal resistance of an electric storage device.

Background

Conventionally, electric storage devices that can be rechargeable, such as secondary batteries, have been used. Internal resistances of such electric storage devices increase as they are repeatedly charged and discharged. As a result, the electric storage devices degrade. If the secondary batteries degrade, desirable performance of the secondary batteries cannot be achieved, which may result in malfunctions of devices in which the secondary batteries are installed. Conventionally, technologies for estimating degradation levels have been known (e.g., Patent Document 1). According to one of the technologies, an internal resistance of an electric storage device is estimated using the number of cycle, which indicates how many times the electric storage device is charged and discharged, and a degradation level of the electric storage device is estimated.

Patent Document 1: JP-A-2011-133443

A degradation level of an electric storage device can be accurately estimated by directly estimating an internal resistance of the electric storage device instead of indirectly estimating the internal resistance of the electric storage device through parameters such as the number of cycle. Conventionally, a technology for feeding a charge current to an electric storage device and estimating an internal resistance of the electric storage device based on the charge current and a terminal voltage of the electric storage device measured while the charge current flows has been used. The technology is known as a technology for directly estimating an internal resistance of an electric storage device.

Summary

The following presents a simplified summary of the invention disclosed herein in order to provide a basic understanding of some aspects of the invention. This summary is not an extensive overview of the invention. It is intended to neither identify key or critical elements of the invention nor delineate the scope of the invention. Its sole purpose is to present some concepts of the invention in a simplified form as a prelude to the more detailed description that is presented later.

An objective of the present invention is to provide a technology for estimating an internal resistance of an electric storage device.

An internal resistance estimation device described in this specification includes a current measurement portion, a voltage measurement portion, and a controller. The current measurement portion is configured to measure a charge current to the electric storage device. The voltage measurement portion is configured to measure a terminal voltage of the electric storage device. The controller is configured to estimate an internal resistance of the electric storage device based on the charge current and the terminal voltage measured in a restrictive period of charge time for charging the electric storage device. The restrictive period is a period in which a time variation in charge current is constant.

Brief Description of Drawings

FIG. 1 is a block diagram illustrating a configuration of a battery pack.

FIG. 2 is a block diagram illustrating a configuration of a battery module.

FIG. 3 is a flowchart illustrating an internal resistance estimation process.

FIG. 4 is a graph illustrating time variations in current value I and voltage value V in charge time.

FIG. 5 is a graph illustrating correlation between current value I and voltage value V.

FIG. 6 is a table containing initial internal resistance values H in relation to temperature D and SOC.

FIG. 7 is a graph illustrating correlation between SOC and internal resistance R.

FIG. 8 is a graph illustrating correlation between temperature D and internal resistance R.

FIG. 9 is a table containing correction values X in relation to temperature D and SOC.

Description of Embodiments

It may be difficult to maintain a flow of a charge current through an electric storage device. For example, charge and discharge of the electric storage device may be repeated at irregular intervals after the electric storage device is installed in an electric vehicle or other device. Namely, it may be difficult to maintain the flow of the charge current through the electric storage device. Even if the flow of the charge current through the electric storage device is maintained, the internal resistance of the electric storage device cannot be estimated based on the charge current if a period in which the charge current remains flowing cannot be determined.

In charge time for charging an electric storage device, an increase in charge current may be regulated such that the charge current to the electric storage device does not exceed a limit immediately after the charge is started. In this restrictive period of the charge time in which the increase in charge current is regulated, the increase in charge current is regulated to a certain control value and thus a time variation in charge current is constant. The inventor has conceived of estimation of internal resistance of an electric storage device using the restrictive period in which the time variation in charge Current is constant.

An internal resistance estimation device in this specification has been made in view of the aforementioned circumstances. The internal resistance estimation device includes a current measurement portion, a voltage measurement portion, and a controller. The current measurement portion is configured to measure a charge current to the electric storage device. The voltage measurement portion is configured to measure a terminal voltage of the electric storage device. The controller is configured to estimate an internal resistance of the electric storage device based on the charge current and the terminal voltage measured in a restrictive period of charge time for charging the electric storage device. The restrictive period is a period in which a time variation in charge current is constant.

In this internal resistance estimation device, an internal resistance of the electric storage device is estimated based on the charge current and the terminal voltage measured in the restrictive period of the charge time in which the time variation in charge current is constant. According to the internal resistance estimation device, an internal resistance of the electric storage device can be estimated during the charge time using the restrictive period.

In this internal resistance estimation device, the controller may be further configured to control charge of the electric storage device such that constant current charge is performed on the electric storage device with a specified current and then constant voltage charge is performed on the electric storage device with a specified voltage. The restrictive period may be a period between when the charge of the electric storage device is started and when the charge current flowing through the electric storage device reaches the specified current. According to the internal resistance estimation device, an internal resistance of the electric storage device can be estimated during the charge time using the period between when the charge of the electric storage device is started and when the charge current flowing through the electric storage device reaches the specified current.

In this internal resistance estimation device, the controller may be further configured to: control the current measurement portion and the voltage measurement portion to simultaneously measure the charge current and the terminal voltage at a plurality of times in the restrictive period to receive a plurality of current values and a plurality of voltage values; and estimate an internal resistance of the electric storage device based on a gradient of the voltage values of the terminal voltage relative to the current values of the charge current. According to the internal resistance estimation device, the gradient of the voltage values of the terminal voltage relative to the current values of the charge current can be obtained by measuring the charge current and the terminal voltage at a plurality of times in the respective period. Then, the internal resistance of the electric storage device can be estimated based on the gradient.

In this internal resistance estimation device, the controller may be further configured to control the charge of the electric storage device according to charge standards. According to the internal resistance estimation device, an increase in charge current is regulated according to predetermined charge standards and thus the increase in charge current is constant. Therefore, an internal resistance of the electric storage device can be estimated during charge time.

The internal resistance estimation device may further include a charge condition detection portion configured to detect an SOC of the electric storage device. The controller may be further configured to estimate the internal resistance of the electric storage device if the SOC of the electric storage device at a start of charge of the electric storage device is equal to or lower than a specified value. The "SOC (state of charge)" indicates a charge state of the electric storage device. The SOC is 100% on a full charge and 0% on a full discharge. According to the internal resistance estimation device, an internal resistance of the electric storage device is measured if the SOC at the start of charge is equal to or lower than the specified value. Therefore, the internal resistance can be accurately estimated.

The internal resistance estimation device may further include a temperature measurement portion configured to measure a temperature of the electric storage device. The controller is further configured to: calculate an internal resistance of the electric storage device based on the charge current and the terminal voltage; correct the internal resistance of the electric storage device based on the temperature of the electric storage device in the charge time; and estimate the internal resistance of the electric storage device. According to the internal resistance estimation device, an internal resistance of the electric storage device can be estimated using the temperature of the electric storage device measured in the charge time.

In internal resistance estimation device, the controller may be further configured to: store a reference internal resistance and correction values defined in relation to temperatures of the electric storage device; select a correction value from the correction values based on the temperature of the electric storage device; calculate a comparative internal resistance based on the selected correction value and the reference internal resistance; compare the internal resistance of the electric storage device with the comparative internal resistance; and correct the internal resistance of the electric storage device. In the internal resistance estimation device, the controller calculates the comparative internal resistance, which is used for correction of the internal resistance of the electric storage device, based on the reference internal resistance and the correction value. Therefore, it is not necessary to store the comparative internal resistance in association with the temperature of the electric storage device.

The internal resistance estimation device may further include a charge condition detection portion configured to detect an SOC of the electric storage device. The controller may be further configured to: calculate an internal resistance of the electric storage device based on the charge current and the terminal voltage; correct the internal resistance of the electric storage device based on the SOC of the electric storage device in the charge time; and estimate an internal resistance of the electric storage device. According to the internal resistance estimation device, an internal resistance of the electric storage device can be estimated using the SOC of the electric storage device measured in the charge time.

In the internal resistance estimation device, the controller may be further configured to: store a reference internal resistance and correction values defined in relation to SOCs of the electric storage device; select a correction value from the correction values based on the SOC of the electric storage device; calculate a comparative internal resistance based on the selected correction value and the reference internal resistance; compare the internal resistance of the electric storage device with the comparative internal resistance; and correct the internal resistance of the electric storage device. In the internal resistance estimation device, the controller calculates the comparative internal resistance, which is used for correction of the internal resistance of the electric storage device, based on the reference internal resistance and the correction value. The controller does not store the comparative internal resistance in association with the temperature of the electric storage device. In comparison to a configuration in which the comparative internal resistance is stored in association with the temperature of the electric storage device, a size of memory space required for the controller can be reduced.

In the charge time, the charge current starts increasing to the specified current immediately after the charge of the electric storage device is started. Namely, the charge current varies to rise. An internal resistance estimation device in this specification is configured to estimate an internal resistance of an electric storage device using the variation. The internal resistance estimation device includes a current measurement portion, the voltage measurement portion, and a controller. The current measurement portion is configured to measure a charge current to the electric storage device. The voltage measurement portion is configured to measure a terminal voltage of the electric storage device. The controller is configured to estimate an internal resistance of the electric storage device based on the charge current and the terminal voltage measured in a ramp region of charge time for charging the electric storage device. The ramp region is a region in which the charge current varies to rise.

In the internal resistance estimation device, the internal resistance of the electric storage device is estimated based on the charge current and the terminal voltage measured in the ram region in which the charge current varies to rise. According to the internal resistance estimation device, the internal resistance of the electric storage device can be estimated during the charge time using the ramp region.

In the internal resistance estimation device, the controller may be further configured to control the charge of the electric storage device such that at least one of constant current charge and constant power charge is performed on the electric storage device. The ramp region is a time region from when the charge of the electric storage device is started to when the electric storage device enters a constant current charge state or a constant power charge state. According to the internal resistance estimation device, the internal resistance of the electric storage device can be estimated during the charge time using the time region from when the charge of the electric storage device is started to when the electric storage device enters the constant current charge state or the constant power charge state.

In the internal resistance estimation device, the controller may be further configured to: control the current measurement portion and the voltage measurement portion to simultaneously measure the charge current and the terminal voltage at a plurality of times in the ramp region to receive a plurality of Current values and a plurality of voltage values; and estimate an internal resistance of the electric storage device based on a gradient of the voltage values of the terminal voltage relative to the current values of the charge current. According to the internal resistance estimation device, the gradient of the voltage values of the terminal voltage relative to the current values of the charge current can be obtained by measuring the charge current and the terminal voltage at a plurality of times in the respective period. Then, the internal resistance of the electric storage device can be estimated based on the gradient.

The internal resistance estimation device may further include a charge condition detection portion configured to detect an SOC of the electric storage device. The controller may be further configured to estimate an internal resistance of the electric storage device if the SOC of the electric storage device at a start of the charge of the electric storage device is equal to or lower than a specified value. According to the internal resistance estimation device, an internal resistance of the electric storage device is measured if the SOC at the start of charge is equal to or lower than the specified value. Therefore, the internal resistance can be accurately estimated.

The invention descried in this specification may be applied to a method of estimating an internal resistance. A method of estimating an internal resistance in this specification is for estimating an internal resistance of an electric storage device. The method includes: measuring a charge current and a terminal voltage of the electric storage device in a restrictive period of charge time for charging the electric storage device; and estimating an internal resistance of the electric storage device based on the measured charge current and the measured terminal voltage. The restrictive period is a period in which a time variation in charge current is constant. According to the method, the internal resistance of the electric storage device can be estimated during the charge time using the restrictive period of the charge time.

According to the present invention, an internal resistance of an electric storage device can be estimated.

First Embodiment

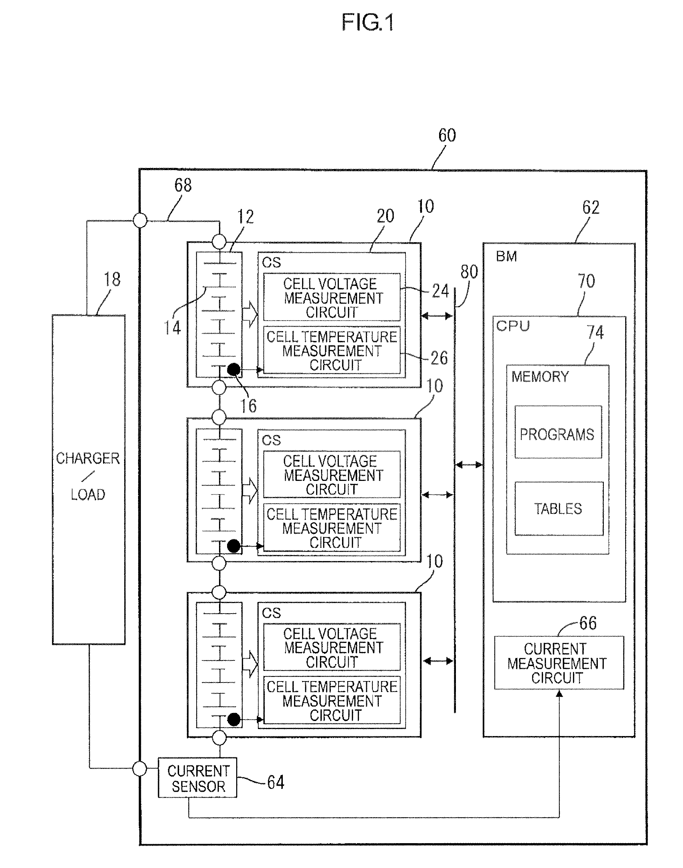

A first embodiment will be described with reference to FIGS. 1 to 8.

1. Configurations of Battery Pack

A battery pack 60 illustrated in FIG. 1 according to this embodiment is installed in an electric vehicle or a hybrid vehicle, for example, for supplying power to electric-powered devices according to control by an electronic control unit (hereinafter referred to as the ECU).

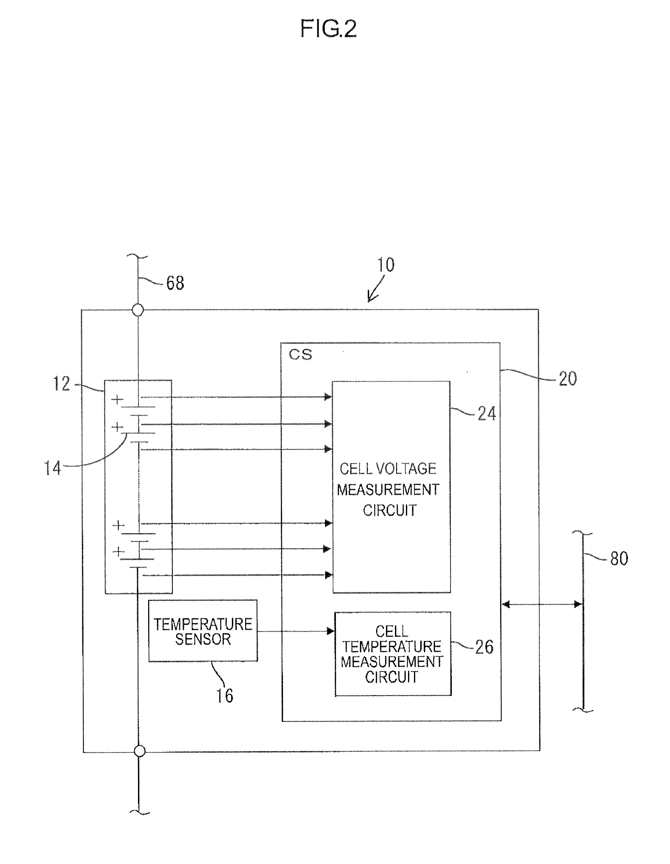

As illustrated in FIG. 1, the battery pack 60 includes a plurality of battery modules 10, a battery manager (hereinafter referred to as the BM) 62, and a current sensor 64. Each battery module 10 includes an assembled battery 12, a temperature sensor 16, and a cell sensor board (hereinafter referred to as the CS) 20. The assembled battery 12 includes a plurality of cells 14 (see FIG. 2). The CS 20 is a circuit board that includes various measurement circuits. The BM 62 is configured to manage the battery modules 10. The BM 62 and the CSs 20 are an example of an internal resistance estimation device. The cell 14 is an example of an electric storage device. The current sensor 64 is an example of a current measurement portion.

The assembled batteries 12 of battery modules 10 and the current sensor 64 are connected in series via wiring 68 and connected to charger/discharger 18. The charger 18 may be arranged outside the electric vehicle and the load 18 may be an electric-powered device arranged inside the electric vehicle.

The BM 62 includes a central processing unit (hereinafter referred to as the CPU) 70 and a current measurement circuit 66. The current measurement circuit 66 is configured to measure a current value I (A) of a charge current fed to the cell 14 or a discharge current from the load 18 (hereinafter referred to as the charge/discharge current) for every predetermined period using the current sensor 64. The CPU 70 is an example of a controller and a charge condition detection portion.

As illustrated in FIG. 1, the CPU 70 includes a memory 74 such as a ROM or a RAM. The memory 74 stores various programs for controlling operations of the CSs 20 (including a battery management program). The CPU 70 controls components of the battery pack 60 according to the programs read out of the memory 74. The CPU 70 is configured to execute an internal resistance estimation process, which will be described later. For example, the CPU 70 executes processes for obtaining current values I measured by the current measurement circuit 66 and detecting SOCs of the respective cells 14. The CPU 70 also executes a process for receiving signals related to conditions of the vehicle sent by the ECU.

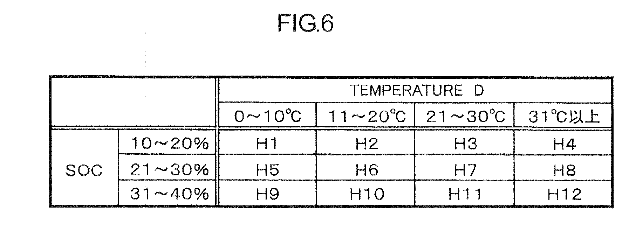

The memory 74 stores a table that contains initial internal resistance values H of the cell 14 in relation to temperature D and SOC of the cell 14 (see FIG. 6), which will be described later. The battery pack 60 includes an operation portion and a display portion (not illustrated). The operation portion is configured to receive inputs from a user. The display portion includes a liquid crystal display configured to display information including degradation levels of the assembled batteries 12.

A configuration of the battery module 10 is schematically illustrated in FIG. 2. The assembled battery 12 includes a plurality of the cells 14 connected in series. Each cell 14 is a secondary battery, which is a rechargeable battery, more specifically, a lithium ion battery, a voltage value across which is about 4V on a full charge. The temperature sensor 16 is arranged so as to be in contact or adjacent to the assembled battery 12.

Each CS includes a cell voltage measurement circuit 24 and a cell temperature measurement circuit 26. The cell voltage measurement circuit 24 is connected across each cell 14 and configured to measure a voltage value V (V), which is a terminal voltage of the cell 14, for every predetermined period. The cell temperature circuit 26 is configured to measure a temperature D (°C) of the assembled battery 12 or each cell 14 with contact or non-contact for every predetermined period using the temperature sensor 16.

Each CS 20 is connected to the BM 62 via a communication line 80 (see FIG. 1) and configured to send information on the voltage values V and temperatures D to the BM 62. The BM 62 is configured to store the voltage values V and the temperatures D sent by each CS 20 in the memory 74 and to estimate internal resistances R of the cells 14 using the information.

2. Internal Resistance Estimation Process

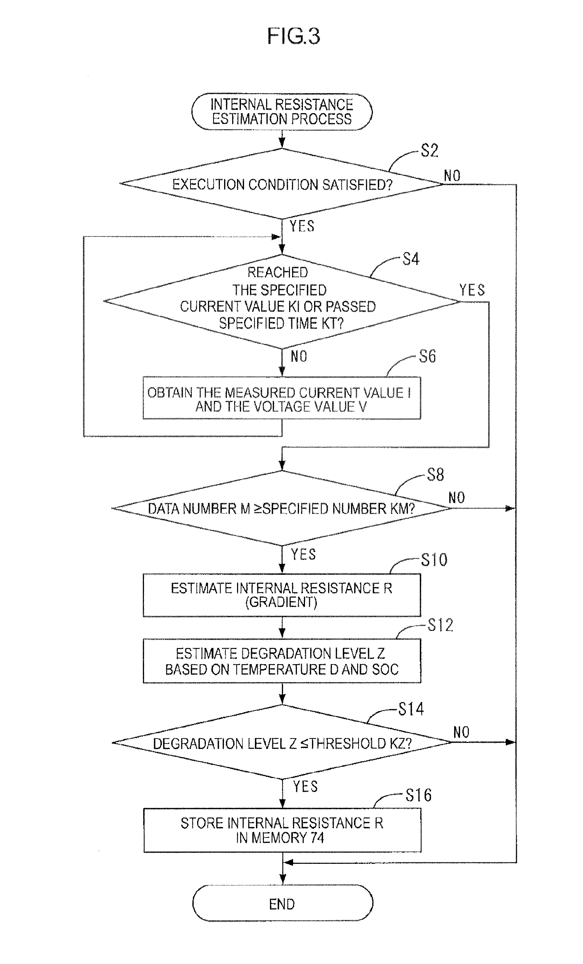

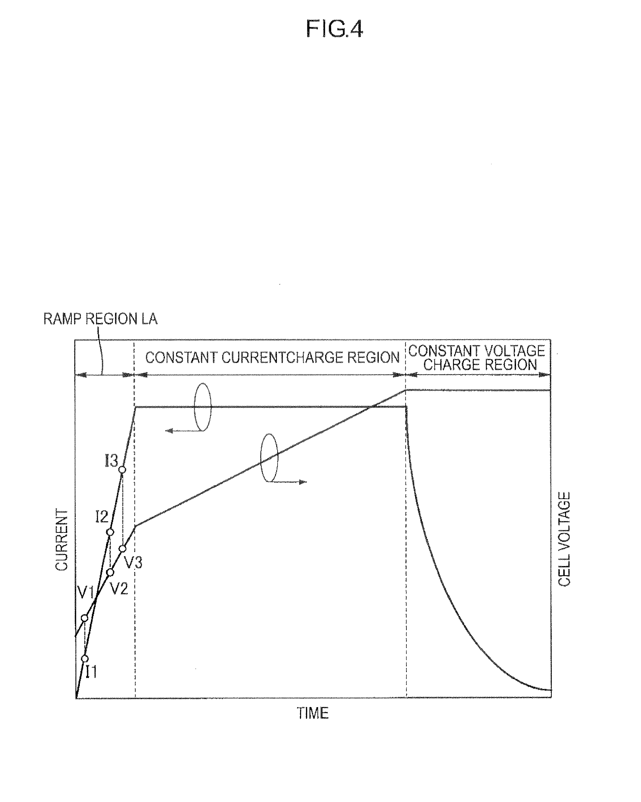

An internal resistance estimation process executed by the CPU 70 during charge of the assembled battery 12 (charge time) for estimating an internal resistance of each cell 14 will be explained with reference to FIGS. 3 to 6. A flowchart of the internal resistance estimation process executed by the CPU 70 is illustrated in FIG. 3. As illustrated in FIG. 4, the charge time includes a ramp region LA. In the ramp region LA, the current value I raises with a time variation ΔI. The current value I is regulated equal to or smaller than a certain reference value due to regulation of increase in current flowing into the assembled battery. The internal resistance R of each cell 14 is estimated based on a current value I and a voltage value V measured in the ramp region LA. Namely, the ramp region LA is a region in which the current value I has a gradient under regulation of the time variation described above.

The estimation of the internal resistance R of the cell 14 may be performed simultaneously for all cells 14 or for the specific cell 14. In this embodiment, the estimation of the internal resistance R is performed for the cell 14, the degradation speed of which is the fastest, that is, the measured voltage value V of which is the lowest among the cells 14 included in the assembled battery 12.

When the battery pack 60 is connected to the charger 18 outside the electric vehicle by the user, for example, the charge of the cells 14 starts. Rapid charge may be performed on the cells 14 by the charger 18 to shorten the charge time for charging the cells 14. In this case, the CPU 70 controls the rapid charge according to predetermined rapid charge safety standards. The rapid charge safety standards may be charge standards for electric vehicles. Safety standards include normal charge standards for normal charge and the rapid charge standards for rapid charge for charging cells more rapidly than the normal charge. As illustrated in FIG. 4, the current value I increases to a specified current value KI after charge is started and the cell 14 is charged according to the rapid charge standards. A region after the ramp region LA is a constant current charge region in which the CPU 70 controls the charge such that the cell 14 is charged with a constant current of the specified current value KI. Furthermore, when the voltage value V of the cell 14 increases to a specified voltage value KV in the constant current charge, the CPU 70 controls the charge such that the cell 14 is charged with a constant voltage having the specified voltage value KV.

The CPU 70 starts the internal resistance estimation process in the following cases: when a signal indicating start of charge for starting charging the cell 14 from the ECU is received; and when the current value I is equal to or larger than an initial current value SI that is set smaller than the specified current value KI. The CPU 70 reads the program out of the memory 74 upon the start of the internal resistance estimation process and then executes the internal resistance estimation process illustrated in FIG. 3.

When the internal resistance estimation process is started, the CPU 70 determines whether an execution condition is satisfied (S2). Specifically, the CPU 70 determines whether the following two conditions of the execution condition are satisfied.

Condition 1: information provided by the ECU indicates that the vehicle is charging.

Condition 2: the SOC of the cell 14 before the charge is started is equal to or lower than 40% (an example of a specified value).

If the execution condition is not satisfied (NO in step S2), the CPU 70 terminates the internal resistance estimation process because accurate estimation of the internal resistance R cannot be performed.

If the execution condition is satisfied (YES in step S2), the CPU 70 determines whether the charge current has reached the specified current value KI or whether elapsed time T since the start of charge has passed specified time KT (S4). The specified time KT is set to time between when the charge is started and when the charge is switched to the constant current charge.

If the above condition is not satisfied, the cell 14 is in the ramp region LA before the constant current charge is started. In the battery pack 60 of this embodiment, the CPU 70 controls the charge to perform the rapid charge on the cell 14 according to the rapid charge standards. Namely, the maximum value of the time variation ΔI in current value I during the charge time is specified, In the ramp region LA illustrated in FIG. 4, the cell 14 is charged with the current such that the time variation ΔI thereof is equal to or close to the maximum value of a specified time variation in the rapid charge standards. As a result, the time variation ΔI in current value I is maintained constant. The ramp region LA is an example of a restrictive period.

If the cell 14 is in the ramp region LA (NO in step S4), the CPU 70 controls the current measurement circuit 66 and the cell voltage measurement circuit 24 of the CS 20 to simultaneously measure the current value I and the voltage value V, and obtain the measured current value I and the voltage value V measured simultaneously and associated with the current I from the current measurement circuit 66 and the cell voltage measurement circuit 24 (S6).

The CPU 70 repeats the current value I and voltage value V obtaining step until the cell 14 enters the constant current charge region. If the cell 14 enters the constant current charge region (YES in step S4), the CPU 70 determines whether the data number M is equal to or larger than a specified number KM (S8). The data number M indicates how many times pairs of the current values I and the voltage values V are obtained in the ramp region LA. If the data number M is smaller than the specified number KM, the internal resistance R cannot be accurately estimated from the obtained pairs of the current values I and the voltage values V. The specified number KM may be 2 for example. If the data number M is smaller than the specified number KM (NO in step S8), the CPU 70 terminates the internal resistance estimation process.

If the data number M is equal to or larger than the specified number KM, that is, a plurality of pairs of the current values I and the voltage values V are obtained in the ramp region LA (YES in step S8), the CPU 70 estimates the internal resistance R (S10). The CPU 70 calculates a gradient of the voltage values V relative to the current values I based on a plurality of obtained pairs of the current values I and the voltage values V and defines the gradient as an internal resistance R of the cell 14.

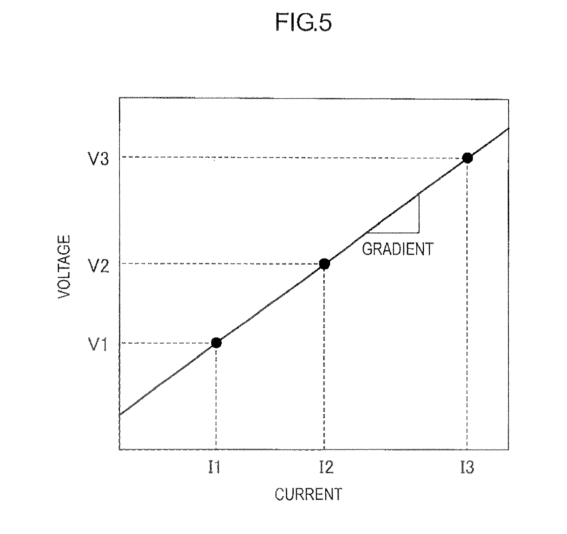

The CPU 70 can accurately calculate the gradient by using a plurality of the obtained combinations of the current value I and the voltage value V as illustrated in FIG. 5. A least-square method, which is a known method, may be used for calculating the gradient.

Then, the CPU 70 estimates a degradation level Z of the cell 14 based on the estimated internal resistance R, the temperature D, the SOC of the cell 14, and the table stored in the memory 74 (S12). Generally, the internal resistance R of the cell 14 is different depending on the temperature D and the SOC of the cell 14 even if the degradation level is the same. The degradation level Z is an index indicating a degradation state of the battery and an example of an internal resistance.

The temperature D and the SOC of the cell 14 are preferably those measured in the ramp region LA of the charge time and further preferably those measured when the current value I and the voltage value V are measured.

The table stored in the memory 74 is in FIG. 6. In the table, a plurality of SOC ranges are present in the second column and a plurality of temperature ranges are provided in the second row. The table contains initial internal resistance values H1 to H12 of the cell 14 in relation to the respective combinations of the SOC ranges and the temperature ranges. The initial internal resistance values H are an example of a comparative internal resistance.

The initial internal resistance values H1 to H12 are actual measurements of the cell 14 in the initial state. The initial internal resistance values H1 to H12 may be defined based on actual measurements of a specific cell 14 or estimated values of the internal resistances R based on the actual measurements of the specific cell 14. The initial internal resistance values H1 to H12 are measured for the respective combinations of the SOC ranges and the temperature ranges in the initial state and stored in the memory 74.

For estimating the degradation level Z of the cell 14, the CPU 70 selects one of the initial internal resistance values H1 to H12 corresponding to the temperature D and the SOC of the cell 14 measured in the ramp region LA. Then, the CPU 70 calculates a ratio of the internal resistance R of the cell 14 to the selected initial internal resistance value H and defines the value of the ratio as a degradation level Z of the cell 14.

Degradation level Z = internal resistance R/initial internal resistance value H

Then, the CPU 70 determines whether the degradation level Z is equal to or lower than a threshold KZ (S14). The threshold KZ is a value calculated in consideration of the number of cycles of the cell 14. If the degradation level Z is higher than the threshold KZ, it means that the internal resistance R estimated in step S10 takes a value that exceeds tolerance limits of increase of the internal resistance R due to degradation. If the degradation level Z is higher than the threshold KZ (NO in step S14), the CPU 70 determines that the measurement of the current value I and the voltage value V in step S6 is erroneous and terminates the internal resistance estimation process.

If the degradation level Z is equal to or lower than the threshold KZ (YES in step S14), the CPU 70 stores the internal resistance R estimated in step S10 in the memory 74 together with the temperature D, the SOC, and the number of cycles of the cell 14 before the charge is started (S16). Then, the CPU 70 terminates the internal resistance estimation process. After the internal resistance estimation process, the CPU 70 can execute other processes such as a process for informing the user of the degradation of the cell 14 using the internal resistance R stored in the memory 74.

3. Evaluation of Internal Resistance

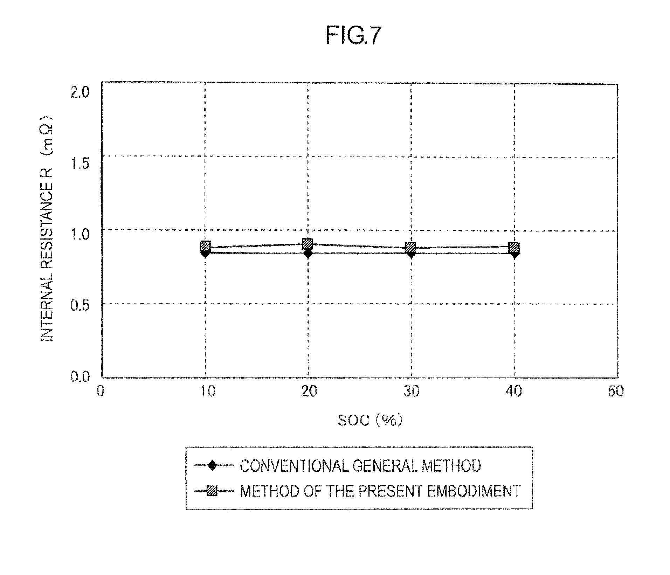

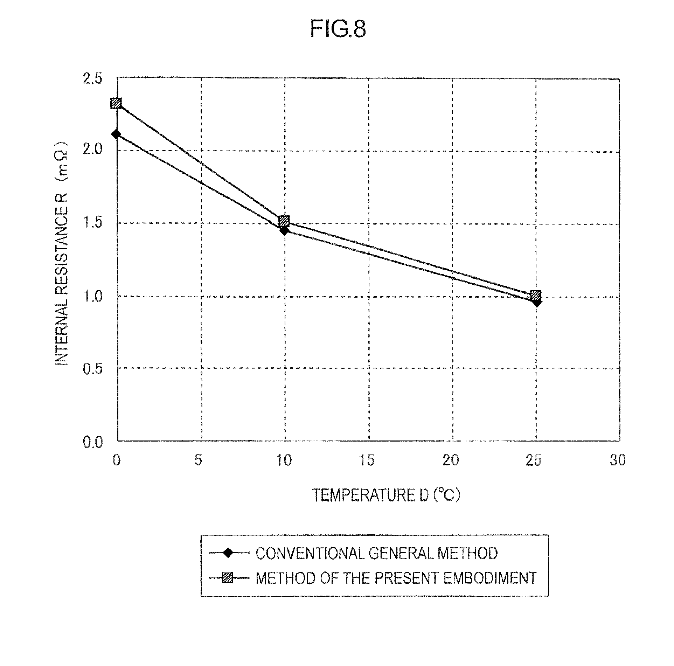

The internal resistances R of the cell 14 obtained through the internal resistance estimation process of this embodiment are present in FIGS. 7 and 8. In FIG. 7, a correlation between SOC and internal resistance R of the cell 14 when the temperature of the cell 14 is at 25°C is present. In FIG. 8, a correlation between temperature D and internal resistance R of the cell 14 when the SOC of the cell 14 is 30% is present. In FIGS. 7 and 8, internal resistances R of the same cell 14 obtained through a conventional general method are present as comparative examples. The conventional general method may be a method for measuring a voltage value V of the cell 14 while a constant current having the current value I is fed to the cell 14. In this method, the measurement is repeatedly performed at a plurality of times with pauses (i.e., the current value I is 0 ampere), the current value I is altered at every measurement, and an internal resistance R of the cell 14 is defined using a plurality of pairs of the current values I and the voltage values V. This method is a common method used in evaluation tests of secondary batteries.

As illustrated in FIGS. 7 and 8, the internal resistances R of the cell 14 obtained through the internal resistance estimation process of this embodiment are substantially the same as the internal resistances R of the cell 14 obtained through the conventional general method. In the internal resistance estimation process of this embodiment, the feed of the constant current having the current value I to the cell 14 is not required. Therefore, the internal resistances R of the cell 14 can be accurately estimated even if the cell 14 is already installed in the electric vehicle and the feed of the constant current to the cell 14 for defining the internal resistances R is difficult.

4. Effects

(1) In the internal resistance estimation process of this embodiment, the internal resistance R of the cell 14 is estimated based on the current value 1 and the voltage value V measured in the ramp region LA. The ramp region is a region between when the charge of the cell 14 is started and when the charge of the cell 14 is switched to the constant current charge.

It is difficult to feed a constant current having the current value I to the cell 14 installed in the electric vehicle for defining the internal resistance R of the cell 14. On the other hand, the time variation $\Delta I$ in Current value I is maintained constant in the ramp region LA because the time variation $\Delta I$ in current value I during rapid charge is regulated according to the rapid charge standards.

In the internal resistance estimation process of this embodiment, the internal resistance R of the cell 14 is estimated using the ramp region LA in which the time variation $\Delta I$ in current value I is maintained constant according to the rapid charge standards. Therefore, the internal resistance R of the cell 14 can be accurately estimated in the charge time of the cell 14.

(2) In the internal resistance estimation process of this embodiment, the obtainment of the current value I and the voltage value V is performed multiple times in the ramp region LA, and the internal resistance R of the cell 14 is estimated using the current values I and the voltage values V. Therefore, the gradient of the voltage values V relative to the current values I can be calculated and the internal resistance R of the cell 14 can be estimated based on the gradient.

(3) In the internal resistance estimation process of this embodiment, the internal resistance R is estimated if the execution condition is satisfied. Therefore, the internal resistance R of the cell 14 can be accurately estimated.

(4) In the internal resistance estimation process of this embodiment, the degradation level Z is estimated using the temperature D and the SOC of the cell 14 and the table. Therefore, the degradation of the cell 14 can be accurately estimated.

Second Embodiment

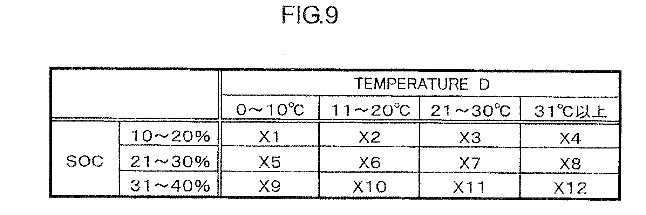

A second embodiment will be described with reference to FIG. 9. The battery pack 60 of this embodiment uses a different method from that of the first embodiment for estimating a degradation level Z in the internal resistance estimation process. The same configurations as those of the first embodiment will not be described.

1. Internal Resistance Estimation Process

A table stored in the memory 74 is in FIG. 9. The table contains correction values X1 to X12 in relation to SOC ranges and temperature ranges.

The correction values X1 to X12 are defined based on the initial internal resistance values H1 to H12. Specifically, each correction value is a ratio of the initial internal resistance value H1, H2, ..., or H12 and an internal resistance R0 measured in a reference condition of the initial condition (e.g., temperature D = 25°C, SOC = 50%). The internal resistance R0 is an example of a reference internal resistance.

$$\text{Correction value X} = \text{initial internal resistance value H/internal resistance R0}$$

To estimate the degradation level Z of the cell 14 (S12), the CPU 70 selects a correction value X corresponding to the temperature D and the SOC of the cell 14 measured in the ramp region LA from the correlation value X1 to X12 in the table. Then, the CPU 70 converts the internal resistance R of the cell 14 to an internal resistance RX in the reference condition by dividing the internal resistance R of the cell 14 estimated in step S10 (see FIG. 3) by the selected correction value X. The CPU 70 defines the value of the ratio of the internal resistance RX to the internal resistance R0 as an estimated degradation level X of the cell 14.

$$\text{Internal resistance RX} = \text{internal resistance R/correction value X}$$

$$\text{Degradation level Z} = \text{internal resistance RX/internal resistance R0}$$

2. Effects

In the internal resistance estimation process of this embodiment, the correction values X and the internal resistance R0 are stored in the memory 74 instead of the initial internal resistance values H. It is not necessary to store the initial internal resistance values H in the respective SOC ranges and temperature ranges in the memory 74.

Other Embodiments

The present invention is not limited to the embodiments described above and illustrated in the drawings. The following various embodiments are also included in the technical scope of the present invention.

(1) In the above embodiments, the cell 14 of the secondary battery is used as an example of an electric storage device. However, the electric storage may be a capacitor in which an electrochetnical phenomenon occurs.

(2) In the above embodiments, the table that contains data in relation to temperature D and SOC of the cell 14 is used for estimating the degradation level Z. However, a table that contains data in relation to any one of the temperature D and the SOC of the cell 14 may be used. Even if the estimation of the degradation level Z is performed using the table that contains data in relation to any one of the temperature D and the SOC of the cell 14, the degradation level Z can be more accurately estimated in comparison to a case in which estimation of the degradation level Z is performed without using the table.

(3) Furthermore, the settings of the SOC ranges and the temperature ranges in the tables in FIGS. 6 and 9 can be altered as appropriate. For example, the SOC ranges may be set between 0% and 100%, and the temperature ranges may be set between 0°C and 60°C. It is not necessary to set the SOC ranges every 10% and the temperature ranges every 10°C. The accuracy in estimation of the degradation level Z can be increased by finely setting the SOC ranges and the temperature ranges.

(4) In the early stage of the internal resistance estimation process of each embodiment, a determination step is executed for determining whether the execution condition is satisfied. However, it is not necessary to execute the determination step. Furthermore, the conditions of the execution condition used in the above embodiments are an example. They can be altered as necessary according to the kind and the intended use of the cell 14.

(5) In the above embodiments, the time variation $\Delta I$ in current value I in the ramp region LA is maintained constant according to the rapid charge standards. However, it is not necessary to maintain the time variation $\Delta I$ constant. The time variation $\Delta I$ may be variable. Namely, it is not necessary to maintain the time variation $\Delta I$ constant as long as the current varies and a gradient of the current values I is present.

For example, if the current value I varies according to a non-linear function, such as a quadratic function, an internal resistance R can be estimated based on a ratio between a coefficient of an approximate equation of the current value I and a coefficient of an approximate equation of the voltage value I obtained when the current value I and the voltage value I are approximated to non-linear functions. For example, the current value I may be expressed by an equation $I = A \times T^2$, where T is an elapsed time, and the voltage value V may be expressed by an equation $V = A \times B \times T^2 + V0$, where T is an elapsed time. In this case, the internal resistance R may be estimated based on a difference ($\Delta V$) between voltage values V measured at predetermined time T1 and predetermined time T2 and a difference ($\Delta I$) between current values I measured at predetennined time T1 and predetermined time T2. The non-linear functions may be trigonometric functions, multidimensional functions, or any other types of functions rather than the quadratic functions.

(6) The standards for maintaining the time variation $\Delta I$ constant is not limited to the rapid charge standards. For example, the time variation $\Delta I$ may be maintained constant according to the normal charge standards. When charge is performed according to the normal charge standards, the charge takes longer hours than the rapid charge. The period in which the time variation $\Delta I$ in current value I is maintained constant is not limited to the ramp region LA.

(7) In the above embodiments, the internal resistance estimation process is performed on the cell 14, the degradation of which is the fastest. However, the internal resistance estimation process may be performed on all cells 14 simultaneously. In this case, an average voltage value of the voltage values V of multiple cells 14 included in the assembled battery 12 may be used as the voltage V of the cell 14. If the cell 14, the voltage V of which can be measured at the same time as the measurement of the current value I, is specified, the voltage value V of the specified cell 14 may be measured.

(8) In the above embodiments, the BM 62 including a single CPU 70 is provided as an example of a controller. However, a controller including a plurality of CPUs, a controller including a hardware circuit such as an application specific integrated circuit (ASIC), and a controller including both CPU(s) and ASIC(s) may be used. Namely, the controller can have any configuration as long as the internal resistance estimation process can be executed through software or a hardware circuit.

(9) In the above embodiments, the program that is read and executed by the CPU 70 is stored in the memory 74. However, the program may be stored in a non-volatile memory such as a hard disk device and a flash memory or on a storage medium such as a CD-R.

(10) In the above embodiments, the ramp region before the constant current charge of the constant-current-charge-to-constant-voltage-charge process is used as a region in which the gradient of the current values I is present. However, the charge process is not limited to the above process. For example, a ramp region before constant power charge of a constant-power-charge-to-constant-voltage charge process may be used. Alternatively, a ramp region before constant current charge of a constant current charge process, a ramp region before constant power charge of a constant power charge process, or a ramp region of any other charge process may be used.

**Claims**

1. An internal resistance estimation device for estimating an internal resistance of an electric storage device comprising:

a current measurement portion configured to measure a charge current to the electric storage device;

a voltage measurement portion configured to measure a terminal voltage of the electric storage device; and

a controller configured to estimate an internal resistance of the electric storage device based on the charge current and the terminal voltage measured in a restrictive period of charge time for charging the electric storage device, the restrictive period being a period in which a time variation in charge current is constant.

2. The internal resistance estimation device according to claim 1, wherein

the controller is further configured to control charge of the electric storage device such that constant current charge is performed on the electric storage device with a specified current and then constant voltage charge is performed on the electric storage device with a specified voltage, and

the restrictive period is a period between when the charge of the electric storage device is started and when the charge current flowing through the electric storage device reaches the specified current.

3. The internal resistance estimation device according to claim 1 or 2, wherein the controller is further configured to:

control the current measurement portion and the voltage measurement portion to simultaneously measure the charge current and the terminal voltage at a plurality of times in the restrictive period to receive a plurality of current values and a plurality of voltage values; and

estimate an internal resistance of the electric storage device based on a gradient of the voltage values of the terminal voltage relative to the current values of the charge current.

4. The internal resistance estimation device according to any one of claims I to 3, wherein the controller is further configured to control the charge of the electric storage device according to charge standards.

5. The internal resistance estimation device according to any one of claims 1 to 4, further comprising a charge condition detection portion configured to detect an SOC of the electric storage device, wherein the controller is further configured to estimate the internal resistance of the electric storage device if the SOC of the electric storage device at a start of the charge of the electric storage device is equal to or lower than a specified value.

6. The internal resistance estimation device according to any one of claims 1 to 5, further comprising a temperature measurement portion configured to measure a temperature of the electric storage device, wherein the controller is further configured to:

calculate an internal resistance of the electric storage device based on the charge current and the terminal voltage;

correct the internal resistance of the electric storage device based on the temperature of the electric storage device in the charge time; and

estimate the internal resistance of the electric storage device.

7. The internal resistance estimation device according to claim 6, wherein the controller is further configured to:

store a reference internal resistance and correction values defined in relation to temperatures of the electric storage device;

select a correction value from the correction values based on the temperature of the electric storage device;

calculate a comparative internal resistance based on the selected correction value and the reference internal resistance;

compare the internal resistance of the electric storage device with the comparative internal resistance; and

correct the internal resistance of the electric storage device.

8. The internal resistance estimation device according to any one of claims 1 to 6, further comprising a charge condition detection portion configured to detect an SOC of the electric storage device, wherein the controller is further configured to:

calculate an internal resistance of the electric storage device based on the charge current and the terminal voltage;

correct the internal resistance of the electric storage device based on the SOC of the electric storage device in the charge time; and

estimate an internal resistance of the electric storage device.

9. The internal resistance estimation device according to claim 8, wherein the controller is further configured to:

   store a reference internal resistance and correction values defined in relation to SOCs of the electric storage device;
   select a correction value from the correction values based on the SOC of the electric storage device;
   calculate a comparative internal resistance based on the selected Correction value and the reference internal resistance;
   compare the internal resistance of the electric storage device with the comparative internal resistance; and
   correct the internal resistance of the electric storage device.

10. An internal resistance estimation device for estimating an internal resistance of an electric storage device comprising:

    a current measurement portion configured to measure a charge current to the electric storage device;
    a voltage measurement portion configured to measure a terminal voltage of the electric storage device; and
    a controller configured to estimate an internal resistance of the electric storage device based on the charge current and the terminal voltage measured in a ramp region of charge time for charging the electric storage device, the ramp region being a region in which the charge current varies to rise.

11. The internal resistance estimation device according to claim 10, wherein
    the controller is further configured to control the charge of the electric storage device such that at least one of constant current charge and constant power charge is performed on the electric storage device, and
    the ramp region is a time region from when the charge of the electric storage device is started to when the electric storage device enters a constant current charge state or a constant power charge state.

12. The internal resistance estimation device according to claim 10 or 11, wherein the controller is further configured to:

    control the current measurement portion and the voltage measurement portion to simultaneously measure the charge current and the terminal voltage at a plurality of times in the ramp region to receive a plurality of current values and a plurality of voltage values; and
    estimate an internal resistance of the electric storage device based on a gradient of the voltage values of the terminal voltage relative to the current values of the charge current.

13. The internal resistance estimation device according to any one of claims 10 to 12, further comprising a charge condition detection portion configured to detect an SOC of the electric storage device, wherein the controller is further configured to estimate an internal resistance of the electric storage device if the SOC of the electric storage device at a start of the charge of the electric storage device is equal to or lower than a specified value.

14. A method of estimating an internal resistance of an electric storage device, the method comprising:

    measuring a charge current and a terminal voltage of the electric storage device in a restrictive period of charge time for charging the electric storage device, the restrictive period being a period in which a time variation of the charge current is constant; and
    estimating an internal resistance of the electric storage device based on the measured charge current and the measured terminal voltage.

# FIG.1

# FIG.2

# FIG.3

```
        ┌─────────────────────────┐
        │   INTERNAL RESISTANCE    │
        │    ESTIMATION PROCESS    │
        └─────────────────────────┘
                    │
                    ▼                          S2
              ◇─────────────────────────◇      NO
              < EXECUTION CONDITION SATISFIED? >─────────┐
              ◇─────────────────────────◇                │
                    │ YES                                 │
                    ▼                                     │
         ┌──────────────────────────┐  S4                │
         │        REACHED           │                    │
         │     THE SPECIFIED        │          YES        │
         < CURRENT VALUE KI OR PASSED >─────────┐         │
         │    SPECIFIED TIME KT?    │           │         │
         └──────────────────────────┘           │         │
                    │ NO             S6          │         │
                    ▼                            │         │
         ┌──────────────────────────┐           │         │
         │ OBTAIN THE MEASURED       │           │         │
         │ CURRENT VALUE I           │           │         │
         │ AND THE VOLTAGE VALUE V   │           │         │
         └──────────────────────────┘           │         │
                    │◄──────────────────────────┘         │
                    ▼                    S8                │
              ◇─────────────────────────◇      NO         │
              < DATA NUMBER M ≥SPECIFIED NUMBER KM? >──────┤
              ◇─────────────────────────◇                 │
                    │ YES                 S10              │
                    ▼                                      │
         ┌──────────────────────────┐                     │
         │ ESTIMATE INTERNAL         │                     │
         │ RESISTANCE R (GRADIENT)   │                     │
         └──────────────────────────┘                     │
                    │                    S12               │
                    ▼                                      │
         ┌──────────────────────────┐                     │
         │ ESTIMATE DEGRADATION      │                     │
         │ LEVEL Z BASED ON          │                     │
         │ TEMPERATURE D AND SOC     │                     │
         └──────────────────────────┘                     │
                    │                    S14               │
                    ▼                                      │
              ◇─────────────────────────◇      NO          │
              < DEGRADATION LEVEL Z ≤THRESHOLD KZ? >───────┤
              ◇─────────────────────────◇                  │
                    │ YES                S16               │
                    ▼                                      │
         ┌──────────────────────────┐                     │
         │ STORE INTERNAL            │                     │
         │ RESISTANCE R IN MEMORY 74 │                     │
         └──────────────────────────┘                     │
                    │◄──────────────────────────────────────┘
                    ▼
              ┌───────────┐
              │    END    │
              └───────────┘
```

# FIG.4

## FIG.5

FIG.6

| | | TEMPERATURE D | | | |
|---|---|---|---|---|---|
| | | 0～10℃ | 11～20℃ | 21～30℃ | 31℃以上 |
| SOC | 10～20% | H1 | H2 | H3 | H4 |
| | 21～30% | H5 | H6 | H7 | H8 |
| | 31～40% | H9 | H10 | H11 | H12 |

## FIG.7

## FIG.8

FIG.9

| | | TEMPERATURE D | | | |
|---|---|---|---|---|---|
| | | 0〜10℃ | 11〜20℃ | 21〜30℃ | 31℃以上 |
| SOC | 10〜20% | X1 | X2 | X3 | X4 |
| | 21〜30% | X5 | X6 | X7 | X8 |
| | 31〜40% | X9 | X10 | X11 | X12 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011133443 A